# EUROPEAN PATENT SPECIFICATION

(11) **EP 2 162 906 B1**
(45) Date of publication and mention of the grant of the patent: **02.10.2013**
(21) Application number: 08774503.0
(22) Date of filing: 29.06.2008
(51) Int. Cl.: H01L 21/768, H01L 23/532, H01L 23/485

(54) **A METHOD FOR PRODUCING A COPPER CONTACT**
VERFAHREN ZUR HERSTELLUNG EINES KUPFERKONTAKTES
PROCÉDÉ PERMETTANT DE PRODUIRE UN CONTACT EN CUIVRE

(30) Priority: 29.06.2007 EP 07111392
(43) Date of publication of application: 17.03.2010
(73) Proprietor: IMEC, 3001 Leuven (BE); Taiwan Semiconductor Manufacturing Company, Ltd., Hsinchu 300-077 (TW)
(72) Inventor: LIU, CHUNG-SHI, B-3080 Tervuren (BE); BEYER, Gerald, B-3001 Leuven (BE); DEMUYNCK, Steven, B-3200 Aarschot (BE); TOKEI, Zsolt, B-3000 Leuven (BE); PALMANS, Roger, B-3770 Riemst (BE); ZHAO, Chao, B-3010 Kessel-lo (BE); CHEN-HUA, Yu, Hsin-chu (TW)
(74) Representative: Pronovem
(86) International application number: PCT/EP2008/058346
(87) International publication number: WO 2009/003972

(56) References cited:
- JP-A- 2007 059 660
- US-A1- 2005 035 460
- US-A1- 2005 218 519
- PAN J ET AL: "Novel approach to reduce source/drain series resistance in high performance CMOS devices using self-aligned CoWP process for 45nm node UTSOI transistors with 20nm gate length" 2006 SYMPOSIUM ON VLSI TECHNOLOGY (IEEE CAT. NO. 06CH37743C) IEEE PISCATAWAY, NJ, USA, 2006, page 2 pp., XP002498879 ISBN: 1-4244-0004-X cited in the application

## Description

### Field of the Invention

The present invention is related to the production of integrated circuits, in particular to the production of a copper contact in the transition between Front End of Line and Back End of Line stages of the production process.

### State of the Art

Contacts between FEOL and BEOL are typically obtained by producing holes in the Pre-metal dielectric (PMD) layer, e.g. SiO₂, and filling these holes with tungsten (W) metal. As contact dimensions shrink, replacing W by copper (Cu) is advantageous due to lower intrinsic resistivity of Cu metal. For both approaches (W and Cu) a metal barrier is required between the contact metal and silicided source/drain and gate areas, at the bottom of the hole. In the case of Cu this barrier is necessary to prevent the formation of harmful Cu-silicates. In order to control the resistance increase associated with the smaller contacting area, the barrier thickness has to be scaled down without compromising the reliability. Typically Cu barriers are deposited using Physical Vapour Deposition (PVD)-based techniques which inherently deliver aspect-ratio dependent bottom & sidewall coverage thicknesses, which is limiting the scalability of PVD barriers. Prior art techniques include the use of ALD TaN, delivering a conformal barrier, which is however inefficient at preventing Cu-silicidation at very low thicknesses (2-3nm), and tends to suffer from poor adhesion properties.

In conclusion, in order to use Cu in the contacts between FEOL and BEOL, a need exists in the prior art to provide a suitable barrier on the sidewalls and bottom of the contact hole, which on the one hand solves the problem of resistance increase due to the shrinkage in dimensions and on the other hand avoids the leakage of copper and hence the formation of copper silicides in and around the copper contact.

From Usui et al (IEEE Transactions on Electron Devices, vol. 53, n° 10, October 2006), it is known to produce copper dual-damascene interconnects in the Back End of Line, by filling a via with a CuMn alloy by sputtering a CuMn seed layer on the side walls of the via, performing Cu deposition by electrochemical plating, annealing and removal of excess Cu by Chemical Mechanical Polishing. During annealing, Mn reacts with SiO₂, resulting in the formation of MnSiₓO_{y}, on the sidewall of the hole, which acts as an effective barrier. This method cannot be used as a stand-alone option for Cu contacts since the technique would not provide a barrier on the metal silicide bottom of the contact hole. A similar method is known from JP 2007 059660.

The self-aligned deposition of CoWP on a source or drain region is known from Pan et al (2006 Symposium on VLSI Technology - 1-4244-0005-8/06). According to this technique, it is possible to deposit CoWP selectively on silicided areas using an electroless metal deposition process. The goal of the CoWP layer onto the silicided source and drain areas is to decrease the series resistance and hence improve the electrical contact.

### Aims of the Invention

The present invention aims to provide a more effective and scalable way of producing a Cu contact between FEOL and BEOL.

It is a first aim of the invention to provide a robust conductive barrier at the bottom of a Cu contact, said conductive barrier having at least a low contact resistance (preferably lower than in prior art) and said conductive barrier preventing Cu to react with silicide or Si.

It is a second aim of the invention to provide a thin barrier (preferably thinner than in prior art) at the contact sidewalls, said thin(ner) barrier serving as a barrier to avoid leakage of Cu into the surrounding Pre Metal Dielectric (PMD).

### Summary of the invention

The present invention is related to a method and device as disclosed in the appended claims. Preferred embodiments are described in combinations of the independent claims with claims dependent thereon.

In particular, the invention is related to a method for providing a suitable barrier layer into copper contact vias situated in the Pre-Metal Dielectric (PMD) layer (e.g. SiO₂) of a semiconductor device.

The present invention is further related to a novel semiconductor device comprising copper contacts having a novel combination of barrier layer(s) on the bottom of the contact and on the sidewalls of the contact.

The aim of the invention is achieved by depositing a first selective barrier at the bottom of the via whereby said first barrier layer is selected from a CoWP layer or a CoWB layer and depositing a second thin barrier layer onto the sidewalls of the via whereby said second barrier layer comprises an oxide comprising Mn. Hereafter the term 'Mn-oxide' is used to indicate an oxide comprising Mn and possibly other components, e.g MnSiₓO_{y} with x between 0 and 100% and y higher than 0%.

The expression 'between FEOL and BEOL' is to be understood as follows : between source/drain and gate areas and a metal interconnect region (also called first metallisation region) of an integrated circuit. Furthermore, a 'barrier' in the context of the present invention is to be understood as a copper-barrier, i.e. a layer which inhibits the diffusion of Cu through said layer.

### Brief Description of the Drawings

The drawing is intended to illustrate some aspects and embodiments of the present invention.

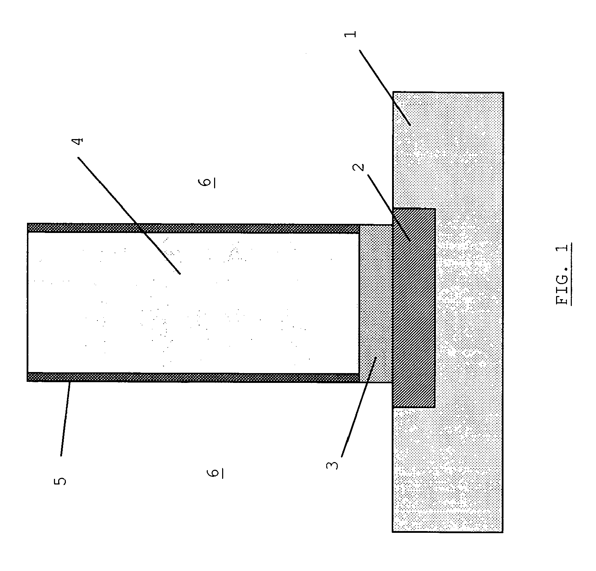

Fig. 1 shows a schematic view of a Cu contact produced according to the present invention.

### Detailed description of the Invention

The above indicated aims are accomplished by methods and devices according to the present invention.

The methods according to embodiments of the invention are scalable and fully compatible with existing semiconductor processing.

With reference to fig. 1, the present invention is related to a method for producing a contact through the pre-metal dielectric layer (6) of an integrated circuit, between the Front End of Line and the Back End of Line, wherein said PMD layer comprises oxygen, said method comprising the steps of :
- producing a hole in the PMD,
- depositing a conductive barrier layer (3) at the bottom of the hole,
- depositing a CuMn alloy on the bottom and side walls of the hole,
- filling the remaining portion of the hole with Cu,
- performing an anneal step,
- performing a CMP step.

The method is preferably performed on a substrate 1, e.g. a silicon substrate, having one or more silicided areas 2, typically nickel silicide areas (NiSi). These can be source/drain or gate areas of the integrated circuit. On top of the substrate is the pre-metal dielectric 6 which separates the gate and source/drain areas (FEOL) from the interconnect level(s) (BEOL) produced after the FEOL stage. The PMD can be a layer of SiO₂ or a CVD deposited low-k material, such as SiCO(H). An essential feature is that the PMD comprises oxygen.

The production of the hole in the PMD can be performed by any known technique. The conductive barrier layer 3 is a CoWP layer or a CoWB layer.

A pre-treatment of the silicide is preferably performed. This can be a cleaning step. The pre-treatment may involve an HF-based activation of the NiSi by e.g. Pd atoms to initiate CoWP electroless deposition.

The deposition of the conductive barrier 3 at the bottom can be a selective electroless metal deposition step of any one of the following metals: CoWP, CoWB, CoWP(N), CoWB(N), wherein N is Nitrogen, being present in the grain boundaries of the CoWP or CoWB. According to the invention, this particular structure of CoWP(N) or CoWB(N) can be obtained by performing a plasma treatment in an atmosphere comprising NH₃ or N₂, i.e. with a plasma being generated from a gaseous mixture comprising at least nitrogen and/or NH₃, after depositing the barrier layer. The presence of N in the grain boundaries diminishes the diffusion of Cu through these boundaries (i.e. the presence of N avoids the fact that the grain bounderies act as diffusion paths for Cu).

A standard electroless CoWP (or CoWB) plating bath may be used with the typical process conditions inherent to a CoWP (or CoWB) deposition process in micro-electronics. In order to improve the selective electroless metal deposition step, the bottom of the contact hole (silicide) may be pre-treated, or in other words the bottom of the contact via is activated to improve the electroless process (e.g. performing a seeding step).

The thickness of the barrier layer 3 (e.g. CoWP or CoWB) is preferably in the range of 10nm up to 100nm, most preferably around 30nm.

After depositing the barrier layer 3 at the bottom of the via, a pre-treatment step of said barrier layer is preferably performed, to clean the surface of the barrier layer, and specifically in order to substantially remove oxides from the surface of the barrier layer.

The deposition of the CuMn alloy can be performed by depositing a thin layer of CuMn alloy by PVD, for example an alloy comprising Cu and 2-8% Mn. The alloy may be deposited using the same PVD-based process and process conditions as for the subsequent deposition of a pure Cu seed layer which may be needed to perform electrochemical plating of copper to fill the copper contacts with copper.

The filling of the remaining gap with Cu 4 can take place by ECP (Electro-Chemical Plating). A standard acidic Cu plating bath may be used, as used in the microelectronics industry for interconnect fabrication.

The anneal step forms a Mn-Oxide layer 5 at the contact side wall, having a thickness of preferably around 3nm (which is thinner than the known TaN barrier). The annealing step may be performed by a Furnace Thermal Anneal. The temperature and time period of this step depends on the particular alloy used and the nature of the dielectric onto which the barrier has to be formed. Typical temperatures are around 400°C for 20-40min. When the PMD layer comprises Silicon (e.g. PMD is SiO2), the oxide formed may be MnSiₓO_{y} with x between 0 and 100% and y higher than 0%. The self-formed Mn-Oxide diffusion barrier can only be formed at the contact sidewall. No Mn-Oxide will be formed at the contact bottom because there is no oxygen supply at the bottom of the contact hole (the PMD is giving the required oxygen through SiO₂).

The Mn-oxide (e.g. MnSiₓO_{y}) barrier at the sidewalls of the copper contact has a further advantage that it adheres very well to both the copper and the PMD (e.g. SiO₂), in contrast to state of the art barrier materials such as an ALD deposited TaN barrier layer.

The removal of excess Cu takes place by Chemical Mechanical polishing (CMP).

The present invention introduces the novel use of CoWP or CoWB as a barrier material in cooperation with Cu, for the production of Cu contacts between FEOL and BEOL, the layer of CoWP or CoWB being applied at the bottom of a hole filled thereafter with the Cu contact.

The present invention further introduces the novel combination of a CoWP or CoWB as a barrier material at the bottom of a copper contact with a self-forming Mn-oxide barrier layer at the sidewalls of the copper contact. Using this combination it is possible to avoid copper leakage out of the copper contact as well as a low contact resistance within the copper via.

The present invention is further related to a device comprising Cu contact vias through a pre-metal dielectric layer (PMD) comprising oxygen, said contact vias being between source/drain/gate areas 2 and a metal interconnect region, wherein a conductive barrier layer 3 is present at the bottom of the vias and a barrier layer 5 comprising an oxide comprising Mn is present at the sidewalls of the vias. According to the preferred embodiment, the conductive barrier layer comprises or consists of CoWP or CoWB, with N being present in the grain boundaries of the CoWP or CoWB. Preferably, the PMD layer comprises Si (e.g. SiO₂) and said barrier layer on the side walls comprises MnSiₓO_{y} with x between 0 and 100% and y higher than 0%. The conductive barrier layer 3 preferably has a thickness of between 10nm and 100nm, most preferably around 30nm.

The present invention also discloses the use of the novel combination of a CoWP or CoWB as a barrier material at the bottom of a copper contact with a self-forming Mn-oxide barrier layer at the sidewalls of the copper contact in the manufacturing process of a semiconductor device.

It is to be understood that although preferred embodiments, specific constructions and configurations, as well as materials, have been discussed herein for devices according to the present invention, various changes or modifications in form and detail may be made without departing from the scope of this invention as defined by the appended claims.

## Claims

1. A method for producing a contact (4) through the pre-metal dielectric (PMD) layer (6) of an integrated circuit, between the Front End of Line and the Back End of Line, wherein said PMD layer comprises oxygen, said method comprising the steps of :
- producing a hole in the PMD,
- depositing a conductive barrier layer (3) at the bottom of the hole,
- depositing a CuMn alloy on the bottom and side walls of the hole,
- filling the remaining portion of the hole with Cu (4),
- performing an anneal step, to form a barrier (5) on the side walls of the hole, said barrier comprising an oxide comprising Mn,
- performing a CMP step,
**characterized in that**
said conductive barrier layer (3) is a CoWP layer or a CoWB layer, said method further comprising a plasma treatment step after the step of depositing the conductive barrier layer (3), to thereby enhance the barrier properties of said layer (3), wherein said plasma treatment step takes place with a plasma being generated from a gaseous mixture comprising at least nitrogen and/or NH₃.

2. The method according to claim 1, wherein said barrier layer is produced by electroless metal deposition.

3. The method according to any one of claims 1 to 2, wherein said PMD comprises Si and wherein said barrier is a layer of MnSiₓO_{y} with x between 0 and 100% and y higher than 0%.

4. A semiconductor device comprising Cu contact vias through a pre-metal dielectric (PMD) layer (6), said layer comprising oxygen, said contact vias being between source/drain/gate areas (2) and a metal interconnect region, wherein a conductive barrier layer (3) is present at the bottom of the vias and a barrier (5) comprising an oxide comprising Mn is present at the sidewalls of the vias,
**characterized in that**
said conductive barrier layer (3) comprises CoWP or CoWB, and wherein said conductive barrier layer (3) further comprises N in the grain boundaries of said CoWP or CoWB.

5. The device according to claim 4, wherein said PMD layer comprises Si and wherein said barrier layer on the side walls comprises MnSiₓO_{y} with x between 0 and 100% and y higher than 0%.

6. The device according to any one of claims 4 to 5, wherein the conductive barrier layer has a thickness between 10nm and 100nm.

## Patentansprüche

1. Verfahren zur Herstellung eines Kontakts (4) durch eine dielektrische Vormetall (PMD) Schicht (6) einer integrierten Schaltung, zwischen dem vorderen Ende der Linie und dem hinteren Ende der Linie, wobei die PMD Schicht Sauerstoff umfasst, wobei das Verfahren die Schritte umfasst:
- Herstellen eines Lochs in der PMD,
- Ablegen einer leitenden Barriereschicht (3) am Boden des Lochs,
- Ablegen einer CuMn Legierung auf dem Boden und den Seitenwänden des Lochs,
- Füllen des verbleibenden Abschnitts des Lochs mit Cu (4),
- Durchführen eines Temperschritts, um eine Barriere (5) auf den Seitenwänden des Lochs zu bilden, die Barriere ein Oxid umfassend welches Mn umfasst,
- Durchführen eines CMP Schritts, **dadurch gekennzeichnet, dass** die leitende Barriereschicht (3) eine CoWP-Schicht oder eine CoWB-Schicht ist, wobei das Verfahren weiter einen Plasmabehandlungsschritt nach dem Schritt des Ablegens der leitenden Barriereschicht (3) umfasst, um dadurch die Barriereeigenschaften der Schicht (3) zu verbessern, wobei der Plasmabehandlungsschritt mit einem Plasma stattfindet, das von einem Gasgemisch, welches mindestens Stickstoff und/oder NH₃ umfasst, erzeugt wird.

2. Verfahren nach Anspruch 1, wobei die Barriereschicht durch eine stromfreie Metallablage erzeugt wird.

3. Verfahren nach einem der Ansprüche 1 bis 2, wobei die PMD Si umfasst und wobei die Barriere eine Schicht aus MnSiₓO_{y} ist mit x zwischen 0 und 100% und y höher als 0%.

4. Halbleitervorrichtung umfassend Cu-Kontaktdurchgänge durch eine dielektrische Vormetall (PMD) Schicht (6), wobei die Schicht Sauerstoff umfasst, wobei sich die Kontaktdurchgänge zwischen Quell/Drain/Gate Bereichen (2) und einer Metallverbindungsregion befinden, wobei eine leitende Barriereschicht (3) am Boden der Kontaktdurchgänge vorhanden ist und eine Barriere (5) umfassend ein Oxid welches Mn umfasst an den Seitenwänden der Durchgänge vorhanden ist, **dadurch gekennzeichnet, dass** die leitende Barriereschicht (3) eine CoWP oder CoWB umfasst, und wobei die leitende Barriereschicht (3) weiter N in den Korngrenzen des CoWP oder CoWB umfasst.

5. Vorrichtung nach Anspruch 4, wobei die PMD Si umfasst und wobei die Barriereschicht an den Seitenwänden MnSiₓO_{y} umfasst, mit x zwischen 0 und 100% und y höher als 0%.

6. Vorrichtung nach einem der Ansprüche 4 bis 5, wobei die leitende Barriereschicht eine Dicke zwischen 10 nm und 100 nm aufweist.

## Revendications

1. Procédé pour produire un contact (4) à travers la couche pré-métal diélectrique (PMD) (6) d'un circuit intégré, entre l'extrémité avant de ligne et l'extrémité arrière de ligne, ladite couche PMD comprenant de l'oxygène, ledit procédé comprenant les étapes de :
- production d'un trou dans la PMD,
- dépôt d'une couche de barrière conductrice (3) au fond du trou,
- dépôt d'un alliage de CuMn sur les parois du fond et latérale du trou,
- remplissage de la partie résiduelle du trou avec du Cu (4),
- exécution d'une étape de recuit, pour former une barrière (5) sur les parois latérales du trou, ladite barrière comprenant un oxyde comprenant du Mn,
- exécution d'une étape CMP,
**caractérisé en ce que** ladite couche de barrière conductrice (3) est une couche de CoWP ou une couche de CoWB, ledit procédé comprenant en outre une étape de traitement plasma après l'étape de dépôt de la couche de barrière conductrice (3) de manière à améliorer les propriétés de barrière de ladite couche (3), ladite étape de traitement plasma étant effectuée avec un plasma généré à partir d'un mélange gazeux comprenant au moins de l'azote et/ou du NH₃.

2. Procédé selon la revendication 1, ladite couche de barrière étant produite par dépôt de métal autocatalytique.

3. Procédé selon l'une quelconque des revendications 1 à 2, dans lequel ladite PMD comprend du Si et dans lequel ladite barrière est une couche de MnSiₓO_{y}, x étant compris entre 0 et 100 % et y supérieur à 0 %.

4. Dispositif semi-conducteur comprenant des trous d'interconnexion de contact de Cu à travers une couche de pré-métal diélectrique (PMD) (6), ladite couche comprenant de l'oxygène, lesdits trous d'interconnexion de contact étant entre des zones de source/drain/grille (2) et une région d'interconnexion métallique, une couche de barrière conductrice (3) étant présente au fond des trous d'interconnexion et une barrière (5) comprenant un oxyde comprenant Mn étant présente au niveau des parois latérales des trous d'interconnexion,
**caractérisé en ce que** ladite couche de barrière conductrice (3) comprend CoWP ou CoWB, et ladite couche de barrière conductrice (3) comprend en outre N dans les joints de grain dudit CoWP ou CoWB.

5. Dispositif selon la revendication 4, ladite couche de PMD comprenant du Si et ladite couche de barrière sur les parois latérales comprenant MnSiₓO_{y} avec x entre 0 et 100 % et y supérieur à 0 %.

6. Dispositif selon l'une quelconque des revendications 4 à 5, la couche de barrière conductrice ayant une épaisseur comprise entre 10 nm et 100 nm.
